# FASCICULE DE BREVET EUROPEEN

(11) **EP 2 460 196 B1**
(45) Date de publication et mention de la délivrance du brevet: **19.04.2017**
(21) Numéro de dépôt: 10737880.4
(22) Date de dépôt: 26.07.2010
(51) Int. Cl.: H01L 35/32, H01L 27/16

(54) **DISPOSITIF THERMOELECTRIQUE EN TECHNOLOGIE DE SEMI-CONDUCTEURS**
THERMOELEKTRISCHE VORRICHTUNG MIT HALBLEITERTECHNOLOGIE
THERMOELECTRIC DEVICE USING SEMICONDUCTOR TECHNOLOGY

(30) Priorité: 29.07.2009 FR 0903721
(43) Date de publication de la demande: 06.06.2012
(73) Titulaire: ST-Ericsson (Grenoble) SAS, 38000 Grenoble (FR); Commissariat à l'Énergie Atomique et aux Énergies Alternatives, 75015 Paris (FR)
(72) Inventeur: COTTIN, Denis, F-38920 Crolles (FR); SAVELLI, Guillaume, F-38000 Grenoble (FR); REMONDIERE, Vincent, 38000 Grenoble (FR); PLISSONNIER, Marc, F-38320 Eybens (FR)
(74) Mandataire: Talbot, Alexandre
(86) Numéro de dépôt international: PCT/EP2010/060820
(87) Numéro de publication internationale: WO 2011/012586

(56) Documents cités:
- JP-A- 2002 148 288
- ALDRETE-VIDRIO E ET AL: "Differential Temperature Sensors Fully Compatible With a 0.35-m CMOS Process" IEEE TRANSACTIONS ON COMPONENTS AND PACKAGING TECHNOLOGIES, IEEE SERVICE CENTER, PISCATAWAY, NJ, US LNKD- DOI:10.1109/TCAPT.2007.906349, vol. 30, no. 4, 1 décembre 2007 (2007-12-01), pages 618-626, XP011195078 ISSN: 1521-3331 cité dans la demande
- LEE W H ET AL: "Fabrication of thermoelectric sensor using silicon-on-insulator structure" JAPANESE JOURNAL OF APPLIED PHYSICS, JAPAN SOCIETY OF APPLIED PHYSICS, JP LNKD- DOI:10.1143/JJAP.46.7232, vol. 46, no. 11, 1 novembre 2007 (2007-11-01), pages 7232-7236, XP001521237 ISSN: 0021-4922

## Description

### Domaine technique de l'invention

L'invention est relative à un dispositif thermoélectrique, notamment à effet Seebeck, intégré en technologie de semi-conducteurs.

### État de la technique

De nombreux circuits intégrés embarquent aujourd'hui des capteurs thermiques servant à informer de l'échauffement des circuits. Un circuit de gestion de puissance provoquera, par exemple, l'arrêt d'une fonction, le ralentissement d'une horloge, ou le déclenchement d'un ventilateur, lorsque la température du capteur atteint un seuil.

Les capteurs thermiques utilisés aujourd'hui dans les circuits intégrés sont généralement sous la forme d'une jonction p-n polarisée en direct. La tension aux bornes de la diode est indicative de la température de la jonction.

De tels capteurs ont l'inconvénient de consommer un courant permanent, de l'ordre de 20 *µ*A, et surtout d'être peu précis sur le température de seuil (estimée à +/- 20°C). Bien que couramment utilisés aujourd'hui dans les appareils mobiles, les limites d'utilisation de ces capteurs commencent à apparaître du fait de la dissipation de puissance sans cesse croissante dans les boîtiers, liée à l'introduction de fonctions plus rapides ou nouvelles.

Il existe des capteurs autonomes plus précis et sans consommation de courant, appelés capteurs à effet Seebeck. Ils sont aussi connus sous la dénomination de « thermocouples ». Ces capteurs thermiques sont différentiels et nécessitent de disposer simultanément d'une source froide et d'une source chaude.

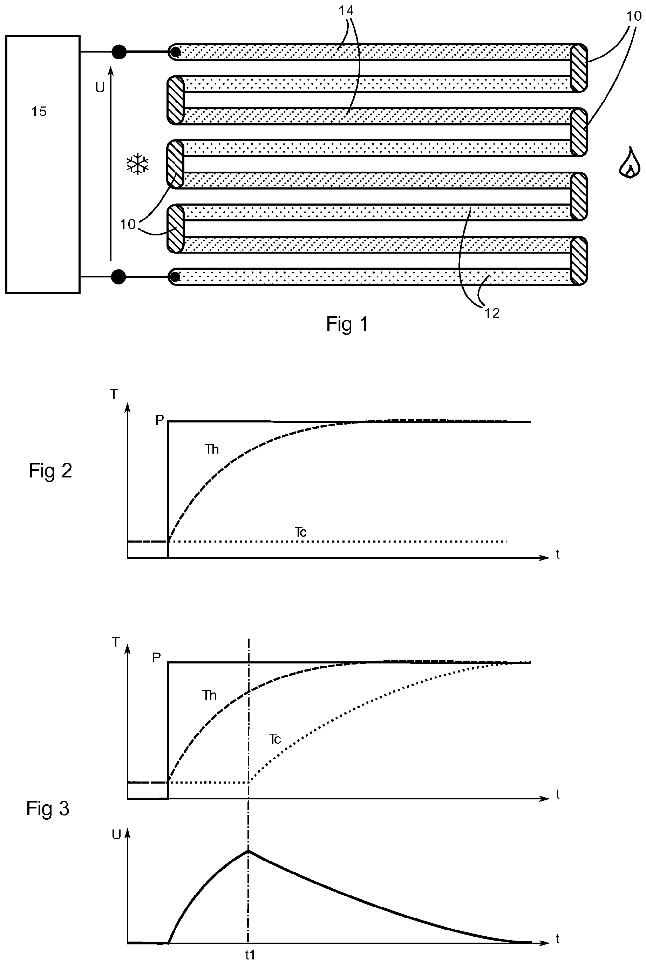

La figure 1 représente un capteur différentiel à effet Seebeck intégré en technologie CMOS, comme cela est décrit dans l'article intitulé « Differential Temperature Sensors in 0.35µm CMOS Technology », publié à la conférence Therminic 2005 par Eduardo Aldrete-Vidrio, Diego Mateo, et Josep Altet.

Sur un substrat en silicium, on a formé plusieurs barreaux conducteurs en parallèle. Une extrémité de ces barreaux se situe au niveau d'une source froide (à gauche) et l'autre extrémité se situe au niveau d'une source chaude (à droite). Les barreaux sont connectés électriquement en série par des métallisations 10. Les barreaux de rang impair 12 et les barreaux de rang pair 14 sont de natures différentes, les uns en silicium polycristallin « poly1 », les autres en silicium polycristallin « poly2 » ou formées par une implantation p+ du substrat. On forme ainsi plusieurs thermocouples au niveau des métallisations 10, disposés en série afin d'augmenter la sensibilité du capteur. Cet agencement est également appelé « thermopile ».

La longueur de la thermopile est de l'ordre de 500 *µ*m, et sa largeur est de l'ordre de 16 *µ*m.

La tension U aux bornes du capteur, fournie à un circuit de mesure 15, est proportionnelle à la différence de température entre les thermocouples situés du côté de la source chaude et les thermocouples situés du côté de la source froide (pour simplifier ci-après on parlera des côtés chaud et froid du capteur). Le coefficient de proportionnalité est lui-même proportionnel au nombre de thermocouples et au coefficient Seebeck du couple de matériaux utilisés pour les barreaux.

La figure 2 représente un exemple d'évolution transitoire de la température du côté chaud Th d'une thermopile en réponse à un échelon de puissance P idéal dissipée par la source chaude.

La température Th croît progressivement et tend asymptotiquement vers la valeur de température correspondant à l'équilibre thermodynamique. Le taux de croissance dépend de la puissance et de la capacité thermique de la source chaude. La valeur maximale dépend de la puissance et de la capacité à évacuer la chaleur de la source chaude.

Dans le cas où la température Tc du côté froid ne varie pas, la tension aux bornes du capteur est directement indicative des variations de température de la source chaude Th.

L'article susmentionné décrit ce genre de capteur dans le cadre de la caractérisation du comportement thermique de blocs fonctionnels sur une puce, et propose de l'intégrer dans des séries de circuits dédiés à la caractérisation thermique. Etant donné l'encombrement du capteur (de l'ordre de 8000 *µ*m²), il ne peut pas être utilisé en l'état dans des circuits intégrés commerciaux dont la taille typique des sources chaudes (des transistors de puissance) est voisine de 150000 *µ*m² (le capteur occuperait 5% de la surface du transistor de puissance). XP011195078 décrit un capteur de différentiel de température composé de capteurs passifs ou de capteurs actifs.

### Résumé de l'invention

On constate qu'il existe un besoin de capteur thermique qui soit à la fois précis, de faible consommation, et adapté par ses dimensions à une utilisation dans des circuits intégrés commerciaux.

Pour satisfaire ce besoin, on prévoit notamment un dispositif thermoélectrique intégré en technologie de semi-conducteurs, comme décrit dans revendication 1, comprenant un côté chaud agencé à proximité d'une source de chaleur, et un côté froid, fournissant un signal fonction de la différence de température entre les côtés chaud et froid. Les côtés chaud et froid sont agencés de manière que leurs températures tendent à s'égaliser lorsque la température de la source de chaleur varie, c'est-à-dire que le capteur se trouve dans de mauvaises conditions de fonctionnement. Un circuit de mesure élabore une information utile en fonction d'une portion continûment variable du signal à partir d'un instant où la température de la source de chaleur varie. Si la température de la source de chaleur cesse de varier, les températures des côtés chaud et froid finissent par s'égaliser et le signal s'annule et cesse de varier. La distance entre les côtés chaud et froid peut être inférieure à 100 *µ*m.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1, précédemment décrite, représente un capteur thermique différentiel à effet Seebeck classique intégré en technologie CMOS ;
- la figure 2, précédemment décrite, représente une évolution transitoire de la température dans un capteur du type de la figure 1 en réponse à un échelon de puissance, dans une situation favorable ;
- la figure 3 représente une évolution transitoire de la température et de la tension dans un capteur du type de la figure 1 en réponse à un échelon de puissance, dans le cas où le côté froid Tc ne peut pas être considéré comme fixe ;
- les figures 4a, 4b et 4c représentent des évolutions transitoires de températures et de tension dans un capteur thermique différentiel d'encombrement réduit, dans trois modes de fonctionnement particuliers ;
- la figure 5 représente un capteur thermique différentiel d'encombrement réduit agencé dans un circuit intégré pour mesurer la température d'un transistor MOS de puissance ;
- la figure 6 représente diverses optimisations pouvant être appliquées à un capteur thermique différentiel d'encombrement réduit ; et
- la figure 7 représente une évolution de températures et de tension mesurées sur un exemple particulier de capteur thermique différentiel d'encombrement réduit.

### Description d'un mode de réalisation préféré de l'invention

Afin de bénéficier des avantages d'un capteur thermique à effet Seebeck, ou différentiel, dans un circuit intégré commercial, il est souhaitable de réduire son encombrement. La largeur du capteur pouvant être dictée par les dimensions de la technologie et par le nombre de jonctions permettant d'atteindre la sensibilité souhaitée, on n'a de latitude que sur la longueur du capteur. Dans les technologies courantes, on souhaite que cette longueur soit inférieure à 100 *µ*m, de préférence inférieure à 50 *µ*m, c'est-à-dire cinq à dix fois plus faible que la longueur du capteur classique décrit en relation avec la figure 1.

Néanmoins, réduire la longueur du capteur implique le rapprochement des sources chaude et froide, ce qui introduit des incovénients qu'on n'a pas su résoudre jusqu'à présent.

La figure 3 représente un exemple d'évolution de températures et de tension U aux bornes d'un capteur thermique à effet Seebeck du type de la figure 1, en réponse à un échelon de puissance P appliqué sur la source chaude, dans une situation défavorable (côté froid Th non thermostatique). Une telle situation est d'autant plus défavorable que l'on réduit la longueur du capteur.

La température Th du côté chaud évolue comme à la figure 2. Cependant, la chaleur générée au niveau de la source chaude est transmise par conduction à la source froide, dont la température Tc commence à croître à partir d'un instant t1, avec un certain retard dépendant de la longueur du capteur et des caractéristiques thermiques de la matière entre les sources chaude et froide. La croissance de la température Tc est moins rapide que celle de la température Th, car la chaleur de la source chaude est diffusée tout autour de cette source, et seule une fraction est diffusée vers la source froide. La température Tc tend asymptotiquement vers la température d'équilibre thermodynamique, dépendant de la capacité d'évacuation de chaleur de la source froide et qui, dans le pire cas représenté, est égale à la valeur maximale de Th.

Jusqu'à l'instant t1, la tension U aux bornes du capteur suit l'évolution de la température Th. A partir de l'instant t1, lorsque la température Tc commence à croître, la tension U se met à décroître vers 0 au fur et à mesure que la température Tc s'approche de la température Th. Avec une longueur de capteur de l'ordre de 50 *µ*m intégré dans les technologies courantes, la durée de cette impulsion de la tension U est de l'ordre de quelques microsecondes. Ainsi le capteur devient inexploitable au bout de quelques microsecondes pour effectuer les mesures évoquées dans l'état de la technique.

En fait, si on analyse de plus près le phénomène d'échauffement d'une zone correspondant à un bloc fonctionnel de circuit intégré, on remarque que la température en régime établi de cette zone s'établit à la température moyenne des dispositifs individuels qui l'échauffent, notamment des transistors de puissance constitutifs du bloc fonctionnel. Ces transistors de puissance fonctionnent généralement en mode haché, c'est-à-dire qu'ils présentent en alternance et à fréquence élevée des phases de conduction et de blocage, correspondant respectivement à des phases d'échauffement et de refroidissement. Même si la température moyenne de la zone est constante, on s'aperçoit que la température au niveau des transistors de puissance varie perceptiblement à la fréquence de hachage.

Ainsi, pour rendre exploitable un capteur différentiel de taille réduite on place son côté chaud à proximité immédiate d'un transistor de puissance responsable d'un échauffement, ou dont on veut mesurer l'échauffement. Le côté froid est placé à l'écart du transistor, de préférence dans une zone qui n'est pas affectée par un autre transistor de puissance et si possible proche d'une prise de masse reliée au plan de masse conducteur du circuit pour bénéficier d'une plus grande inertie thermique. Ensuite, au lieu de mesurer un différentiel de température continu en régime établi, on mesure l'amplitude transitoire du différentiel de température.

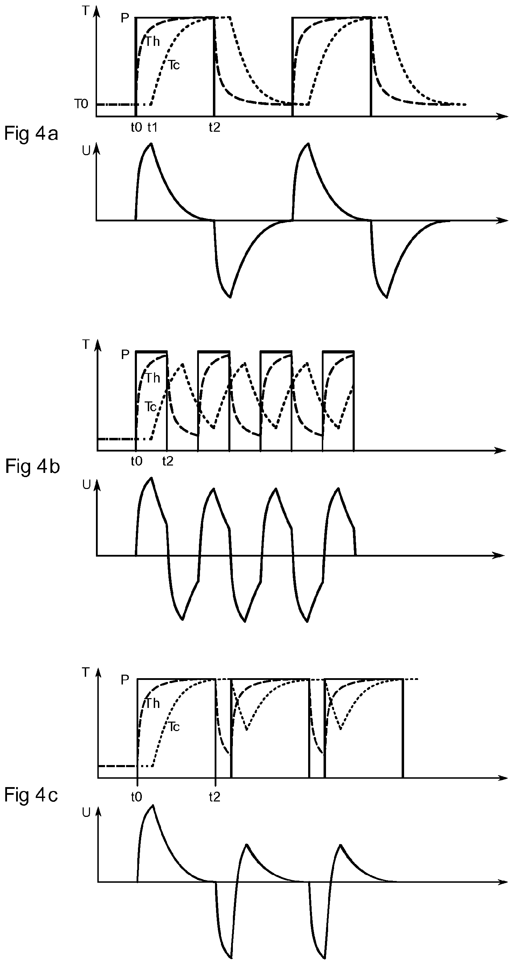

La figure 4a représente un exemple d'évolution des températures côté chaud Th et côté froid Tc, et la tension U correspondante aux bornes du capteur, dans le cas où la phase de conduction du hachage est sensiblement égale au temps que mettent les températures Tc et Th à se rejoindre après une mise en conduction du transistor.

A un instant t0, le transistor est mis en conduction, ce qui correspond à l'application d'un échelon de puissance P. Les températures Th et Tc, et la tension U évoluent comme à la figure 3, en partant d'une température d'équilibre T0 correspondant à la température moyenne de la zone.

A un instant t2, peu après que la température Tc a rejoint la température Th à sa valeur maximale, et que la tension U est retombée à 0, le transistor est bloqué. La tendance des températures Th et Tc s'inverse, instantanément pour la température Th, et avec un retard pour la température Tc, le même retard que dans la phase de conduction du transistor.

La tension U présente une série d'impulsions alternativement positives et négatives dont on pourra aisément mesurer les valeurs crête pour déterminer les conditions d'échauffement du transistor. La valeur crête de la tension U n'indique pas directement l'élévation de température atteinte par le transistor, puisqu'il faudrait y ajouter l'élévation de température de la source froide. Cette valeur crête est néanmoins représentative de l'évolution temporelle de la différence de température (Th-Tc).

Si on souhaite connaître l'élévation de température du transistor en fin de phase de conduction, elle pourra être extrapolée à partir de la courbe de tension U en début de chaque phase de commutation, car, tant que la température côté froid Tc ne commence pas à changer significativement (instant t1), la tension U est directement représentative de l'évolution de la température côté chaud Th. Pour les besoins d'une telle extrapolation, l'instant t1 est identifiable sur le signal U par le fait que le signal U atteint sa valeur crête.

Si la fréquence de hachage diminue, les impulsions de la tension U auront sensiblement la même amplitude et allure, mais elles seront plus espacées.

La figure 4b représente une situation où la fréquence de hachage est plus élevée que dans le cas de la figure 4a. A l'instant t2 où le transistor est bloqué, aucune des températures Th et Tc n'a atteint sa valeur maximale. La température côté chaud Th amorce aussitôt une décroissance tendant asymptotiquement vers la température de départ T0. Par contre, la température côté froid Tc, qui réagit avec retard par rapport à l'évolution de la température Th, continue à croître pendant la durée du retard, puis amorce une décroissance tendant asymptotiquement vers la température de départ. L'évolution devient périodique après quelques cycles de démarrage.

La tension U, proportionnelle à la différence des températures Th et Tc, présente une allure alternative symétrique. On s'aperçoit que les valeurs crête du signal sont inférieures à celles de la figure 4a. Les valeurs crête diminuent lorsque la fréquence de hachage augmente à partir de la situation de la figure 4a, ce qui montre la limite maximale de fréquence de hachage que le capteur est susceptible d'observer compte tenu de ses dimensions et de l'inertie thermique du système. Les transistors que l'on souhaite observer fonctionnent plutôt dans les conditions de la figure 4a, ou à une fréquence de hachage inférieure.

La figure 4c représente une situation où le rapport cyclique du hachage est proche de 1. Les phases de conduction du transistor correspondent à celles de la figure 4a, c'est-à-dire qu'elles sont suffisamment longues pour que les températures Th et Tc atteignent leur valeur maximale. Les phases d'extinction du transistor sont proches du retard de l'évolution de la température côté froid Tc.

Lors de la première phase de conduction démarrant à l'instant t0 et de la première phase d'extinction démarrant à l'instant t2, les températures Th, Tc et la tension U évoluent comme à la figure 4a.

Lorsque démarrent la deuxième phase de conduction et suivantes, la température côté froid Tc n'a pas encore amorcé une décroissance. Il en résulte que seule la température Th évolue pendant les phases d'extinction.

La tension U évolue de manière dissymétrique. Elle n'est représentative de la température Th que pendant les phases d'extinction, où la tension U présente des valeurs crêtes maximales négatives.

Dans la description qui précède des figures 4a à 4c, on suppose que la température de départ T0 est constante. C'est le cas en régime établi où le circuit a atteint sa température moyenne de fonctionnement. En régime transitoire, par exemple à la mise sous tension du circuit, chaque phase de conduction contribue à augmenter la température T0 à partir de la température ambiante.

Un capteur thermique différentiel tel que décrit ici ne se prête pas à une détermination directe des conditions thermiques absolues d'un transistor. Or, dans de nombreuses applications envisageables de gestion de puissance, connaître les variations de température suffit pour déduire des tendances et prendre les mesures souhaitées pour modifier ces tendances. Par exemple, on peut détecter une condition nécessitant une diminution de puissance du fait que la tension U fournie par le capteur augmente plus vite que lors de précédentes phases de conduction du transistor, ou bien que la variation de la tension U dans une phase de conduction dépasse un seuil.

Néanmoins, si on veut connaître les conditions thermiques absolues, on peut les estimer en accumulant les variations signées des valeurs crête de la tension U depuis la mise sous tension du circuit. Cette accumulation est représentative de la température moyenne T0. Par exemple, si on se réfère à la figure 4a, si la température T0 augmente pendant la première phase de conduction, la température Th tend vers la nouvelle valeur de la température T0 pendant la phase d'extinction suivante. Il en résulte que la valeur crête de la tension U pendant cette phase est plus faible en valeur absolue que la valeur crête de la phase précédente, et la différence de ces valeurs crête (en valeur absolue) est représentative de l'augmentation de la température T0.

Pour être plus précis, plutôt que d'accumuler les différences de valeurs crête, on peut accumuler les différences des valeurs asymptotiques, qui seront calculées en extrapolant la courbe de la tension U en début de chaque phase, entre les instants t0 et t1.

Un circuit de mesure exploitant le signal U sera conçu par l'homme du métier en fonction de ses besoins. Il pourra être associé à un calculateur si on veut extrapoler des tendances. Un microcontrôleur existant pour gérer d'autres fonctions du circuit intégré, par exemple la gestion de l'énergie, pourra être programmé pour réaliser les calculs nécessaires, et effectuer les actions souhaitées.

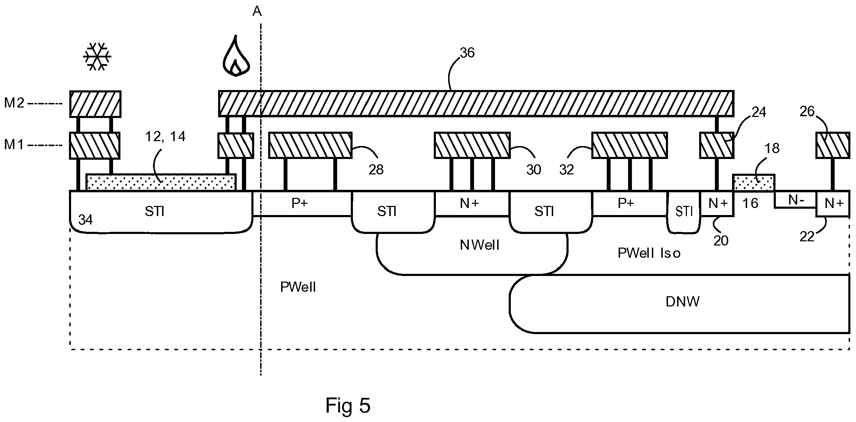

La figure 5 représente un exemple d'intégration d'un capteur thermique différentiel de taille réduite à proximité immédiate d'un transistor MOS de puissance dont on veut mesurer les conditions de fonctionnement thermiques. Le transistor est situé à droite d'un axe A, et le capteur est situé à gauche.

Le circuit intégré est réalisé sur un substrat silicium de type P (PWell). Le transistor MOS, de type N, est de réalisation classique. Il comprend un canal 16 recouvert d'une grille en silicium polycristallin 18. Le canal est délimité par des zones N+ 20 et 22. La zone N+ 22 peut être reliée au canal par une zone « d'extension » N- de plus faible épaisseur, comme cela est représenté. Des contacts 24 et 26, réalisés dans un premier niveau d'interconnexion M1, sont connectés par des vias aux zones N+ 20 et 22, et constituent les électrodes de source et de drain du transistor.

La zone P sous le canal 16 est configurée en caisson isolé (PWell Iso). Ce caisson P est délimité par un caisson N enterré (DNW), et un caisson N périphérique (NWell). Des contacts 28, 30, et 32, réalisés dans le niveau d'interconnexion M1, permettent de prendre contact avec le substrat PWell, le caisson périphérique NWell, et le caisson P isolé (PWell Iso) par l'intermédiaire de zones respectives P+, N+ et P+. Ces diverses zones sont isolées les unes des autres par de l'isolant en tranchée peu profonde (couramment appelé STI, signifiant « shallow trench insulator »).

Le capteur, à gauche de l'axe A, comporte une thermopile telle que décrite en relation avec la figure 1. Les barreaux en silicium polycristallin 12 et 14 du capteur sont disposés sur un isolant en tranchée peu profonde 34, réalisé dans le substrat. Cet isolant électrique s'avère être aussi un isolant thermique limitant la transmission de chaleur entre le substrat et le capteur, ainsi qu'entre les côtés chaud et froid du capteur. On peut envisager d'autres isolants, tels que de l'oxyde épais ou un nitrure.

Le côté froid du capteur, à l'extrême gauche de la figure, est de préférence relié par un pont thermique, formé par un empilement de vias et de métallisations dans les niveaux d'interconnexion successifs (seulement deux sont représentés, M1 et M2), à une plage métallique (non représentée) à la surface de la puce. Cette plage pourra être reliée à un élément dissipateur de chaleur par l'intermédiaire d'une bille de contact. L'objectif est de relier thermiquement le côté froid du capteur idéalement à un thermostat afin de le maintenir à une température Tc aussi constante que possible. En pratique, une bille de contact reliée au plan de masse du circuit peut présenter une bonne inertie thermique par rapport au temps nécessaire à la mesure sur le capteur. Cette inertie thermique peut être augmentée aussi en réalisant des freins thermiques dans le plan de masse pour séparer les prises de masse de puissance des prises de masse de contrôle tel que peut le réaliser l'homme de l'art.

Les vias, que l'on réalise en grand nombre afin de réduire la résistance thermique, ne prennent pas de contact électrique avec les barreaux 12 et 14. Ils viennent sur l'isolant 34 tout autour des extrémités des barreaux pour capter la chaleur. Seuls des vias dédiés viennent relier les contacts de sortie du capteur à des pistes métalliques servant à transmettre la tension U fournie par le capteur à un circuit d'exploitation.

La zone où le transistor s'échauffe est le canal 16. Ainsi, le côté chaud du capteur doit être placé au plus près du canal. Mais, comme cela est représenté, ce côté chaud du capteur peut au mieux être placé en contact avec la périphérie du transistor. Le capteur ne doit pas interférer avec les éléments constitutifs du transistor qui, dans le cas d'un transistor MOS de puissance, tel que cela est représenté, placent le canal relativement loin de la périphérie.

Pour améliorer la transmission de chaleur entre le canal 16 et le côté chaud du capteur, on prévoit de préférence un pont thermique 36, sous forme de métallisation dans le niveau d'interconnexion M2, par exemple. Ce pont est relié par une extrémité à l'électrode de source 24 du transistor et, par l'autre extrémité, au côté chaud du capteur. La liaison se fait par des vias et, le cas échéant, des métallisations des niveaux d'interconnexion intermédiaires (M1 du côté du capteur). Comme pour le côté froid du capteur, les vias du pont thermique 36 viennent au contact de l'isolant STI 34 autour des extrémités des barreaux 12 et 14.

Afin que le pont thermique 36 ait une efficacité optimale, sa largeur (dimension non visible, perpendiculaire au plan de la figure) est choisie égale, du côté du capteur, à la largeur de la thermopile, et, du côté du transistor, à la largeur de l'électrode de source 24.

Le pont 36, formant une masse métallique relativement importante, et donc une capacité électrique importante, il convient de le relier, côté transistor, à un contact qui subit peu de variation de tension. Il s'agit généralement de la source du transistor de puissance, qui est reliée à un potentiel d'alimentation (la masse pour les transistors de type N, et la tension d'alimentation pour les transistors de type P).

Dans les technologies actuelles d'intégration sur silicium, la quantité de métal dans chaque niveau d'interconnexion doit respecter une proportion minimale par rapport à l'isolant comblant l'espace entre les métallisations, ceci afin d'obtenir des états de surface convenables et des épaisseurs homogènes après les opérations de planarisation. Dans le cas du polissage mécano-chimique (CMP), cette proportion est de l'ordre de 10 à 15 %. Cette contrainte est intégrée dans les outils de conception des circuits intégrés, de sorte que ces outils vont automatiquement rajouter des petits plots de métal (appelés « dummies ») régulièrement répartis sur la surface d'un niveau d'interconnexion lorsque la proportion de métal y est insuffisante.

Dans un capteur tel que représenté en figure 5, des « dummies » seraient inévitablement insérés dans chaque niveau d'interconnexion entre les côtés chaud et froid du capteur. Ces « dummies » diminuent la résistance thermique et favorisent l'échauffement du côté froid par le côté chaud. Il en résulte que la longueur du capteur doit être augmentée pour compenser la diminution de la résistance thermique. On obtient toutefois des résultats exploitables avec une longueur de l'ordre de 100 *µ*m.

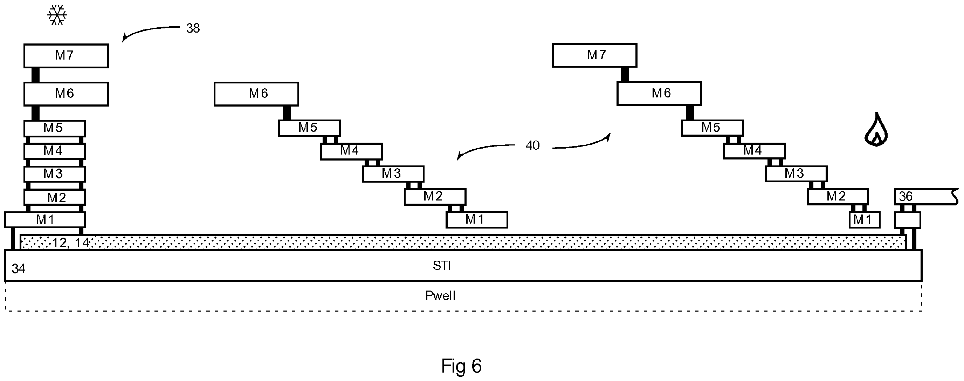

La figure 6 représente une structure de capteur thermique permettant d'optimiser la longueur en tenant compte des contraintes de CMP.

Un principe utilisé dans cette structure est de répartir le minimum de métal, conformément aux besoins technologiques de l'opération de CMP, de manière judicieuse, afin qu'il défavorise la transmission de chaleur entre les côtés chaud et froid du capteur. La technologie utilisée à titre d'exemple comporte sept niveaux d'interconnexion M1 à M7. Dans chacun de ces niveaux, la proportion de métal minimale devrait donc être respectée.

Du côté froid du capteur, comme évoqué en relation avec la figure 5, on prévoit un empilement vertical de métallisations 38 reliées par des vias. La métallisation de niveau M1 est reliée par des vias à l'isolant STI 34 autour des extrémités des barreaux 12, 14 du capteur, sans entrer en contact électrique avec celles-ci, comme cela a été évoqué en relation avec la figure 5. La largeur de ces métallisations, c'est-à-dire leur dimension perpendiculaire au plan de la figure, est de l'ordre de la largeur de la thermopile constituant le capteur.

La métallisation de niveau M7 est de préférence reliée à une plage de contact accessible de l'extérieur du circuit intégré, pouvant être mise directement en contact avec un dissipateur thermique, ou bien être reliée par une bille de contact à une plage métallique d'un circuit imprimé.

Du côté chaud du capteur, on prévoit des structures en escalier 40 ayant des marches métalliques dans des niveaux d'interconnexion successifs M1 à M7. Le premier escalier démarre au premier niveau M1 à l'extrémité chaude du capteur et va en montant vers la surface de la puce en allant vers le côté froid. L'escalier suivant démarre au niveau M1 sensiblement à l'aplomb d'où s'arrête le premier escalier au niveau M7. Avec les dimensions représentées, ce deuxième escalier s'arrête au niveau M6, de manière à rester à l'écart de l'empilement 38 du côté froid.

Si le capteur était plus long, ce deuxième escalier s'arrêterait également au niveau M7, et un troisième escalier démarrerait au niveau M1 à l'aplomb de la dernière marche du deuxième escalier, et ainsi de suite jusqu'à arriver sur l'empilement 38.

Les marches se chevauchent légèrement d'un niveau au suivant de manière à pouvoir être reliées par des vias. Les premières marches, du niveau M1, ne comportent pas de vias les reliant vers le bas. En outre, la première marche du premier escalier, bien que réalisée dans le même niveau M1 que le pont thermique 36, n'est pas reliée au pont thermique. En effet, ces escaliers sont de préférence isolés thermiquement et électriquement des autres éléments du circuit intégré.

La profondeur des marches est choisie de manière que la proportion de métal dans chaque niveau soit égale au minimum requis (10 à 15 %). A titre d'exemple, en technologie CMOS 65 nm, on pourra prendre une profondeur de 2,2 *µ*m pour les marches des niveaux M6 et M7 (où le métal est plus épais), et une profondeur de 1,6 *µ*m pour les autres. Le deuxième escalier pourra démarrer 1,2 *µ*m après la dernière marche du premier escalier.

La largeur des marches est de l'ordre de la largeur de la thermopile constituant le capteur, tout comme la largeur du pont thermique 36.

Les structures en escalier 40 jouent le rôle de déflecteurs thermiques, favorisant une propagation de la chaleur vers le haut, à l'écart du côté froid du capteur. Grâce à cette répartition du métal, on peut réaliser un capteur thermique exploitable d'une longueur de l'ordre de 20 *µ*m seulement.

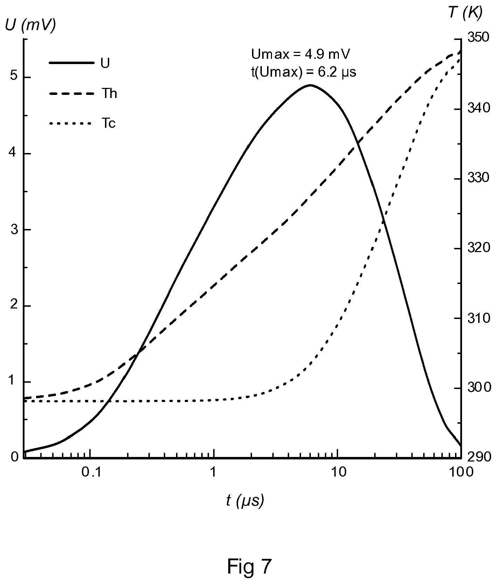

La figure 7 représente une évolution des températures côtés chaud et froid Th, Tc, et de la tension U délivrée par un prototype de capteur du type de la figure 6 en réponse à un échelon de puissance. La thermopile du capteur comporte seulement deux barreaux de silicium polycristallin, de types n et p respectivement, de 20 *µ*m de long.

L'échelon de puissance est tel que la valeur asymptotique de l'élévation des températures est de l'ordre de 50 K. La température Th atteint pratiquement cette valeur au bout de 100 *µ*s. La température côté froid Tc réagit avec un retard d'environ 6 *µ*s après le début de l'échelon. À 6,2 *µ*s après le début de l'échelon, on mesure une tension U maximale de 4,9 mV. En utilisant une thermopile à 8 barreaux, cette valeur est multipliée par 4, tout en disposant d'un capteur présentant un très faible encombrement. On choisira le nombre de barreaux, donc le nombre de jonctions de la thermopile, en fonction de la sensibilité du circuit exploitant la sortie du capteur et de la précision souhaitée.

## Revendications

1. Dispositif thermoélectrique intégré en technologie de semi-conducteurs comprenant un côté chaud (Th) agencé à proximité de la source de chaleur (16), et un côté froid (Tc), le dispositif thermoélectrique fournissant un signal (U) fonction de la différence de température entre les côtés chaud et froid, **caractérisé en ce que** :
• la source de chaleur (16) comporte au moins un transistor MOS de puissance configuré pour fonctionner en mode haché et formant une source de chaleur intermittente avec une période de chauffage et une période de refroidissement,
• la distance entre les côtés chaud (Th) et froid (Tc) est inférieure à 100 *µ*m de manière que leurs températures tendent à s'égaliser lorsque la température de la source de chaleur (16) varie.

2. Dispositif thermoélectrique selon la revendication 1, **caractérisé en ce qu'**il comprend un circuit de mesure élaborant une information utile en fonction d'une portion continûment variable (t0-t1) dudit signal à partir d'un instant où la température de la source de chaleur varie.

3. Dispositif thermoélectrique selon la revendication 1, **caractérisé en ce que** le côté chaud est relié à la source de chaleur par un pont thermique (36) réalisé dans un niveau d'interconnexion de la technologie de semi-conducteurs.

4. Dispositif thermoélectrique selon la revendication 1, **caractérisé en ce qu'**il est réalisé sur un isolant (34).

5. Dispositif thermoélectrique selon la revendication 1, réalisé dans une technologie offrant plusieurs niveaux d'interconnexion (M1-M7) et exigeant une proportion de métal minimale par niveau, **caractérisé en ce qu'**il comprend une structure en escalier (40) partant du côté chaud et s'éloignant du plan du capteur en allant vers le côté froid, les marches de la structure étant réalisées en métal dans des niveaux d'interconnexion successifs.

6. Dispositif thermoélectrique selon la revendication 1, **caractérisé en ce qu'**il comprend un pont thermique (38) reliant le côté froid à une plage accessible de l'extérieur.

7. Dispositif thermoélectrique selon la revendication 3 ou 6, **caractérisé en ce que** le pont thermique (36, 38) comporte des vias disposés autour d'une extrémité du dispositif sans entrer en contact électrique avec le dispositif.

## Patentansprüche

1. Integrierte thermoelektrische Vorrichtung in Halbleitertechnik, umfassend eine warme Seite (Th), die in der Nähe der Wärmequelle (16) angeordnet ist, und eine kalte Seite (Tc), wobei die thermoelektrische Vorrichtung ein Signal (U), das von der Temperaturdifferenz zwischen der warmen und der kalten Seite abhängig ist, liefert, **dadurch gekennzeichnet, dass**:
- die Wärmequelle (16) wenigstens einen MOS-Leistungstransistor umfasst, der dazu ausgelegt ist, im Zerhackermodus zu arbeiten, und der eine intermittierende Wärmequelle mit einer Heizperiode und einer Kühlperiode bildet,
- der Abstand zwischen der warmen (Th) und der kalten (Tc) Seite kleiner als 100 µm ist, so dass ihre Temperaturen dazu neigen, sich auszugleichen, wenn die Temperatur der Wärmequelle (16) variiert.

2. Thermoelektrische Vorrichtung nach Anspruch 1, **dadurch gekennzeichnet, dass** sie eine Messschaltung umfasst, die eine nützliche Information in Abhängigkeit von einem kontinuierlich variablen Abschnitt (t0-t1) des Signals ab einem Zeitpunkt, zu dem die Temperatur der Wärmequelle variiert, erstellt.

3. Thermoelektrische Vorrichtung nach Anspruch 1, **dadurch gekennzeichnet, dass** die warme Seite mit der Wärmequelle über eine Wärmebrücke (36), welche in einer Verbindungsebene der Halbleitertechnik ausgebildet ist, verbunden ist.

4. Thermoelektrische Vorrichtung nach Anspruch 1, **dadurch gekennzeichnet, dass** sie auf einem Isolator (34) ausgebildet ist.

5. Thermoelektrische Vorrichtung nach Anspruch 1, die in einer Technik hergestellt ist, welche mehrere Verbindungsebenen (M1-M7) bietet und einen minimalen Metallanteil pro Ebene erfordert, **dadurch gekennzeichnet, dass** sie eine treppenförmige Struktur (40) umfasst, welche von der warmen Seite ausgeht und sich in Richtung der kalten Seite verlaufend von der Ebene des Sensors entfernt, wobei die Stufen der Struktur aus Metall in aufeinanderfolgenden Verbindungsebenen ausgebildet sind.

6. Thermoelektrische Vorrichtung nach Anspruch 1, **dadurch gekennzeichnet, dass** sie eine Wärmebrücke (38), welche die kalte Seite mit einem von außen zugänglichen Bereich verbindet, umfasst.

7. Thermoelektrische Vorrichtung nach Anspruch 3 oder 6, **dadurch gekennzeichnet, dass** die Wärmebrücke (36, 38) Vias umfasst, die um ein Ende der Vorrichtung herum angeordnet sind, ohne mit der Vorrichtung in elektrischen Kontakt zu gelangen.

## Claims

1. A thermoelectric device integrated in semiconductor technology comprising a hot side (Th) arranged in proximity to a heat source (16), and a cold side (Tc), the thermoelectric device supplying a signal (U) according to the temperature difference between the hot and cold sides, **characterized in that**:
• the heat source (16) comprises at least one MOS power transistor configured to operate in chopped mode and forming an intermittent heat source (16) with a heating period and a cooling period,
• the distance between the hot side (Th) and the cold side (Tc) is less than 100 *µ*m in such a way that their temperatures tend to equal out when the temperature of the heat source varies.

2. The thermoelectric device according to claim 1, **characterized in that** it comprises a measuring circuit providing useful information according to a continuously variable portion (t0-t1) of said signal from a time when the temperature of the heat source varies.

3. The thermoelectric device according to claim 1, **characterized in that** the hot side is coupled to the heat source by a thermal bridge (36) made in an interconnection level of the semiconductor technology.

4. The thermoelectric device according to claim 1, **characterized in that** it is made on an insulator (34).

5. The thermoelectric device according to claim 1 made in a technology providing several interconnection levels (M1-M7) and requiring a minimum proportion of metal per level, **characterized in that** it comprises a stepped structure (40) starting from the hot side and moving away from the plane of the sensor going towards the cold side, the steps of the structure being made from metal in successive interconnection levels.

6. The thermoelectric device according to claim 1, **characterized in that** it comprises a thermal bridge (38) connecting the cold side to a strip accessible from the outside.

7. The thermoelectric device according to claim 3 or 6, **characterized in that** the thermal bridge (36, 38) comprises vias arranged around one end of the device without coming into electric contact with the device.
